Europäisches Patentamt

European Patent Office

Office européen des brevets

(19)

(11) Veröffentlichungsnummer: **0 020 899**
**A1**

(12) # EUROPÄISCHE PATENTANMELDUNG

(21) Anmeldenummer: **80101921.7**

(22) Anmeldetag: **10.04.80**

(51) Int. Cl.³: **H 01 J 33/00**

(30) Priorität: **29.06.79 US 53496**

(43) Veröffentlichungstag der Anmeldung: **07.01.81**
Patentblatt **81/1**

(84) Benannte Vertragsstaaten: **DE FR GB**

(71) Anmelder: **International Business Machines**
**Corporation, Armonk, N.Y. 10504 (US)**

(72) Erfinder: **Dreyfus, Russel Warren, 50 Barker Street,**
**Mt.Kisco, N.Y. 10549 (US)**
Erfinder: **Penebre, Nicholas Angelo, 1 Brevoort Road,**
**Chappaqua, N.Y. 10514 (US)**
Erfinder: **Mc Corkle, Richard Anthony, RR1, Box 210,**
**South Salem, N.Y. 10590 (US)**

(74) Vertreter: **Meyer, Rolf, Dipl.-Phys., Säumerstrasse 4,**
**CH-8803 Rüschlikon/ZH (CH)**

(54) **Ionengenerator.**

(57) Ein Ionengenerator (10) in einer Vakuumkammer erzeugt einen Ionenstrom hoher Stromdichte. Mindestens ein kapillarer Längskanal mit Elektroden (18, 20) an seinen Enden hat eine Innenfläche, welche die Emission von Sekundärelektroden begünstigt. Die auf eine Quelle (30) ionisierbaren Materials einfallenden Elektronen setzen Ionen frei, die in Richtung auf das Target (32) beschleunigt werden.

## Ionengenerator

Die Erfindung betrifft einen Ionengenerator zum örtlichen Beaufschlagen eines Targets in einer Vakuumkammer mit einem Ionenstrom verhältnismässig grosser Stromdichte. Der Ionengenerator enthält einen Längskanal, an dessen Enden Elektroden zum Anlegen einer Beschleunigungsspannung vorgesehen sind.

Ionenkanonen verwenden als Längskanal eine Röhre, an deren Enden eine elektrische Spannung wirksam ist, um die Ionen zu beschleunigen. Einrichtungen dieser Art sind gewöhnlich in der Dichte des erzeugten Ionenstromes begrenzt. Eine solche Einrichtung ist beispielsweise in der US Patentschrift 2 969 480 beschrieben. Die eigentliche Ionenquelle ist dort ein Hohlraumresonator. Die Intensität des Ionenstrahls ist durch die Ergiebigkeit des Hohlraumresonators begrenzt.

In der US Patentschrift 3 233 404 ist ein Ionengenerator beschrieben, der Ionenstrahlen höherer Dichte zu erzeugen ermöglicht. Die Ionenkanone verwendet eine kapillare Röhre aus feuerfestem Metall. Wenn diese Röhre erhitzt ist, kann sie ein durchströmendes Gas thermisch ionisieren. Die Röhre besteht aus Tantal. Sie hat einen Innendurchmesser von 0,4 mm und eine Länge von etwa 10 mm. Wenn sie auf 2100°K erhitzt ist und gasförmiges Caesium hindurch geleitet wird, dann wird ein Ionenstrom mit einer Dichte von etwa 1 A/cm$^2$ erzeugt. Die Ausbeute ist begrenzt durch die Ergiebigkeit der Ionenquelle, weil das Gas durch die Oberfläche des feuerfesten Metalls thermisch ionisiert wird. Aus diesem Grunde ist auch ihr Energiespektrum weitverteilt.

In einem Aufsatz "Self-Triggered Channel Ion Source" berichten C. Bouchard und J.D. Carette in Rev. Sci. Instrum., 50 (1) pp. 99-101 (Jan. 1979) über einen linearen Sekundärelektronenvervielfacher des Dynodentyps mit einem Längskanal und einem Ionenreflektor. Damit diese Einrichtung funktionsfähig ist, muss das Vakuum besser als 10$^{-5}$ Torr sein. Die Stromdichte ist auf 10$^{-3}$ A/cm$^2$ begrenzt. Auch bei dieser Einrichtung ist das Energiespektrum weitgestreut. Die erwähnten bekannten Einrichtungen sind nur in begrenzten Druckbereichen voll arbeitsfähig.

Es ist ein Ziel der Erfindung, einen Ionengenerator anzugeben, der einen grossen Ionenstrom liefert und auch gleichzeitig ermöglicht, den erhaltenen Strahl scharf zu bündeln. Weiterhin soll der Ionengenerator in einem grossen Druckbereich arbeitsfähig sein von Ultra-Hochvakuum bis herauf zu etwa 0,5 Torr. Das Energiespektrum des erzeugten Ionenstrahls soll eine enge Bandbreite haben. Weiterhin soll das Energieniveau der erzeugten Ionen einstellbar sein. Der erzeugte Ionenstrahl soll so scharf gebündelt sein, dass es möglich ist, mit dem Strahl auf der Oberfläche einer Auftreffplatte oder eines Targets zu schreiben. Die seitliche oder transversale Ausdehnung des Ionengenerators soll so gering sein, dass man eine Anzahl solcher Generatoren in dichter Packung benachbart anordnen kann.

Gemäss der Erfindung ist der Ionengenerator der eingangs genannten Art dadurch gekennzeichnet, dass ein hochohmiger Körper mindestens einen kapillaren Längskanal enthält, dass die Innenseite jeder Kapillare eine Oberfläche aufweist, welche die Emission von Sekundärelektronen begünstigt, und dass benachbart einer Elektrode eine Quelle von durch Elektronen ionisierbarem Material vorgesehen ist.

Die Erfindung wird anhand von Ausführungsbeispielen mit Hilfe der Zeichnung näher erläutert.

Fig. 1 zeigt ein erstes Ausführungsbeispiel des Ionengenerators.

Fig. 2 zeigt ein zweites Ausführungsbeispiel des Ionengenerators.

Der Ionengenerator hat im wesentlichen einen Körper mit hohem elektrischen Widerstand. An beiden Enden sind Elektroden zum Anlegen einer Beschleunigungsspannung angebracht. Ein Längskanal von kapillaren Abmessungen durchläuft den Körper und beide Elektroden. Die Innenseite der Kapillaren ist teilweise leitend ausgebildet und begünstigt die Emission von Sekundärelektronen. Eine Spannungsquelle ist vorgesehen, um an die Elektroden eine Beschleunigungsspannung anlegen zu können. Eine Quelle mit ionisierbarem Material steht mit einer Elektrode in Verbindung und stellt die erwünschten Ionen zur Verfügung.

Vorzugsweise hat der kapillare Längskanal eine effektive Durchlassbreite kleiner als 200 $\mu$m und eine solche Längenausdehnung, dass das Verhältnis seiner Längenausdehnung zur genannten Durchlassbreite im Bereich zwischen 100:1 und 1000:1 liegt.

Ein anderes Ausführungsbeispiel ist insbesondere für eine Einrichtung geeignet, die Muster schreiben kann.

In diesem Falle enthält der hochohmige Körper eine Anzahl von parallelen kapillaren Längskanälen. Die einzelnen Kapillaren sind in gleicher Weise aufgebaut wie bei dem oben erwähnten ersten Ausführungsbeispiel.

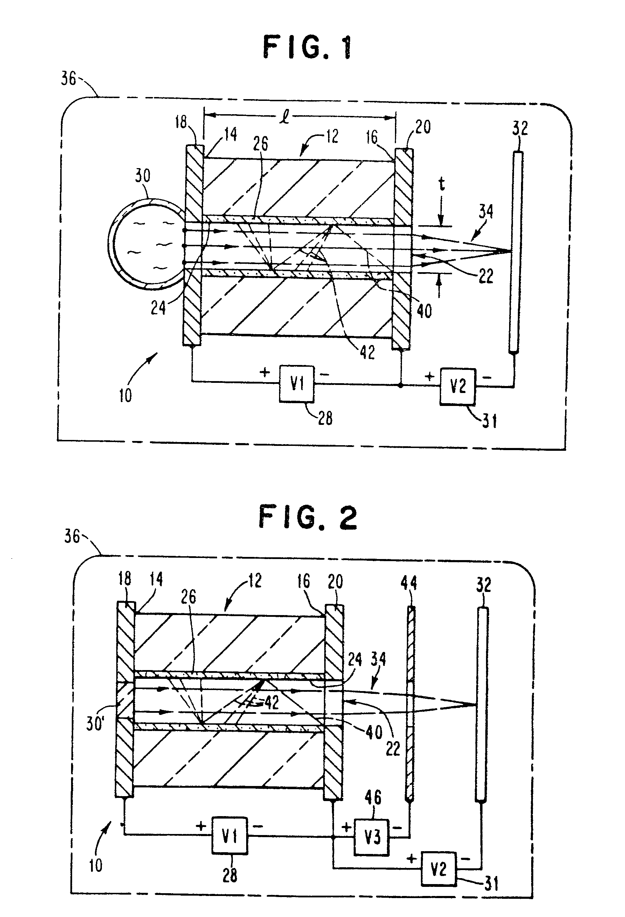

Fig. 1 zeigt ein erstes Ausführungsbeispiel der Erfindung. Ein Ionengenerator 10 besitzt einen Körper 12 mit hohem elektrischen Widerstand, ein erstes Ende 14, das eine erste Elektrode 18 trägt, und ein zweites Ende 16 mit einer zweiten Elektrode 20. Der hochohmige Körper 12 soll einen Widerstand grösser als $10^6$ Ohm haben, wenn man eine Durchgangsmessung zwischen der ersten Elektrode 18 und der zweiten Elektrode 20 vornimmt. Der Körper kann aus einem Material mit geringer Leitfähigkeit hergestellt sein, wie beispielsweise Glas, Plastik, Keramik oder ein Halbleiter.

Ein kapillarer Längskanal 22 durchdringt die erste Elektrode 18, den hochohmigen Körper 12 und die zweite Elektrode 20. Die Oberfläche seiner Innenseite 24 ist so zusammmengesetzt, dass die Oberfläche teilweise eine Leitfähigkeit aufweist und die Emission von Sekundärelektronen begünstigt. Diese Eigenschaften sollten so sein, dass der zwischen den Elektroden 18 und 20 gemessene Gesamtwiderstand des Körpers einschliesslich der Auskleidung im Bereich zwischen $10^6$ und $10^{10}$ Ohm liegt. Der Gesamtwiderstand mag von den Eigenschaften des hochohmigen Körpers 12 herrühren. Man kann aber auch in unmittelbarer Nachbarschaft der Innenseite ein besonderes Gebiet 26 mit den Widerstand beeinflussenden Eigenschaften vorsehen, so dass der gemessene Gesamtwiderstand in der erwünschten Grössenordnung liegt.

Insbesondere sollte das Material so ausgewählt werden, dass die Oberfläche der Innenseite der Kapillaren eine geeignete Austrittsarbeit für die Emission von Elektronen hat. Auch sollte das Material für die Auskleidung

0020899

so gewählt sein, dass eine Erosion durch die Kapillare durchlaufende Elektronen und Ionen möglichst klein gehalten wird. Geeignete Materialien sind Blei, Wismut und Platin. Durch den Einbau solcher Elemente in die Innenseite 24 wird auch die Fähigkeit zur Emission von Sekundärelektronen verbessert. Vergleiche die Literaturstelle "The Energy Dependence of Secondary Emission Based on the Range-Energy Retardation Power Formula" in J. Phys. D: Appl. Phys., Band 12, 1979, Seiten 619 bis 632.

Wenn man wünscht, als Auskleidung ein Gebiet 26 angrenzend an die Oberfläche der Innenseite 24 vorzusehen, das die oben beschriebenen Eigenschaften aufweist, dann kann man den kapillaren Längskanal 22 mit dem Oxid eines Metalles geeigneter Austrittsarbeit auskleiden. Anschliessend wird das Oxid in einer Wasserstoffatmosphäre teilweise reduziert, um ein teilweise leitfähiges Gebiet 26 zu bilden. Dieses Verfahren wird beispielsweise durch Becker und Mitautoren in dem Artikel "Preparation and Characteristics of a Channel Electron Multiplier" in der Zeitschrift The Review of Scientific Instruments, Band 43, No. 11, November 1972, auf den Seiten 1587 bis 1589 beschrieben.

Vorzugsweise hat der kapillare Längskanal 22 eine charakteristische seitliche Ausdehnung, die nicht grösser als 200 $\mu$m ist. Die Länge 1 wird so gewählt, dass das Verhältnis Länge zur Querausdehnung in dem Bereich 100:1 bis 1000:1 liegt. Wenn ein zylindrischer Längskanal 22 wie in Fig. 1 verwendet wird, dann ist die effektive Durchlassbreite der Durchmesser t des kapillaren Längskanals 22. Wird ein prismatischer Längskanal mit beispielsweise dreieckigem oder sechseckigem Querschnitt gewählt, dann ist die effektive Durchlassbreite durch den Durchmesser des in den Querschnitt einbeschriebenen Kreises gegeben. Es kann eine beliebige Querschnittsform gewählt werden, nur muss noch eine ausreichende Vervielfachung von Sekundärelektronen durch die Einrichtung gewährleistet werden.

Eine erste Spannungsquelle 28 oder ein anderes geeignetes äqualentes Mittel hält die erste Elektrode 18 auf einem Potential, das um die Spannungsdifferenz V1 oberhalb der Spannung an der zweiten Elektrode 20 liegt.

Eine Quelle von ionisierbarem Material ist in unmittelbarer Nachbarschaft zu der ersten Elektrode 18 angeordnet und steht mit dem kapillaren Längskanal 22 in Verbindung. Diese Quelle kann beispielsweise ein Vorratsraum 30 sein, der ein Material in gasförmigem oder flüssigen Zustand enthält, wie in der Fig. 1 dargestellt. Die Fig. 2 zeigt eine andere Ausführungsform in Gestalt eines ionisierbaren Festkörpers 30'. Das Material wird nach seiner Fähigkeit ausgewählt, durch einen Elektronenfluss ionisiert zu werden.

Ionisierbare einatomige Gase sind beispielsweise die Edelgase wie Argon, Krypton und Xenon. Ionisierbare molekulare Gase sind beispielsweise organische Gase mit niederem Molekulargewicht wie Methan und Propan.

Im Falle von Flüssigkeiten und Festkörpern als Ionenquelle wählt man zweckmässig Materialien mit niedriger Austrittsarbeit. Beispiele sind Kalium, Gallium und Caesium. Beispiele für geeignete Festkörper sind Barium, Beryllium und Kalzium.

Eine zweite Spannungsquelle 31 ist an die zweite Elektrode 20 und das Target 32 angeschlossen, um eine Spannungsdifferenz V2 aufrechtzuerhalten, die so gewählt ist, dass man den Ionenstrahl 34 je nach Wunsch entweder verbreitert oder fokussiert.

0020899

Um arbeitsfähig zu sein, schliesst man den Ionengenerator 10 in eine Vakuumkammer 36 ein, die strichpunktiert in der Zeichnung angedeutet ist. Der Druck wird auf 0,5 Torr oder geringere Werte reduziert. Wenn die zweite Elektrode 20 durch eine Spannungsdifferenz V1 mittels der ersten Spannungsquelle 28 auf einem geringeren Potential als die erste Elektrode 18 gehalten wird, dann werden Elektronen von der zweiten Elektrode 20 emittiert. Diese Elektronen 40 fallen auf die Oberfläche der Innenseite 24 des kapillaren Längskanals 22 ein. Durch emittierte Sekundärelektronen 42 wird die Zahl der einfallenden Elektronen vervielfacht. Jedes der erzeugten Sekundärelektronen vervielfacht den Effekt, wenn sich die Elektronen durch den kapillaren Längskanal 24 in Richtung auf die erste Elektrode 18 bewegen. Die im Längskanal erzeugten und beschleunigten Elektronen erzeugen eine Wechselwirkung mit dem ionisierbaren Material im Vorratsraum 30. Die erzeugten positiven Ionen werden durch die angelegte Spannung in Richtung auf die zweite Elektrode 20 durch den Längskanal 22 beschleunigt. Ein Ionenstrahl 34 tritt durch die Oeffnung der zweiten Elektrode 20 in Richtung auf das Target 32 aus. Ein geringer Anteil dieser Ionen wird durch die zweite Elektrode 20 eingefangen und erzeugt zusätzliche Elektronen, die ihrerseits zum Elektronenstrom in der anderen Richtung beitragen. Auch können zusätzliche Elektronen während der Prozesse durch Photoemission erzeugt werden. Der grösste Teil der erzeugten Ionen wird jedoch von dem Ionengenerator 10 als Ionenstrahl 34 in Richtung auf das Target 32 ausgeschleudert.

Wenn der Ionenstrahl 34 schärfer gebündelt werden soll, dann hält die zweite Spannungsquelle 31 die zweite Elektrode 20 auf einem Potential, das höher als das des Targets 32 ist. Umgekehrt, wenn die zweite Spannungsquelle 31 die zweite Elektrode 20 auf einem Potential hält, das geringer als das des Targets 32 ist, dann wird der Ionen-

0020899

strahl 34 verbreitert. So kann der Ionenstrahl wunschgemäss eingestellt werden. Für die regelbaren Spannungsquellen wählt man das Verhältnis der gegenseitigen Verstellbarkeit bis etwa 1:9.

Der zwischen den Elektroden an den Enden des Körpers gemessene Gesamtwiderstand liegt im Bereich von $10^6$ bis $10^{10}$ Ohm. Die erste Spannungsquelle 28 sollte kontinuierlich zwischen 200 Volt und 5000 Volt einstellbar sein. Bei geringer Spannung der ersten Spannungsquelle 28 und abgeschalteter zweiter Spannungsquelle 31 wird ein starker Ionenstrom erzeugt, wobei die Ionen selbst verhältnismässig geringe Energie haben. Wenn andererseits die erste Spannungsquelle auf einem hohen Spannungswert gehalten wird, beispielsweise 5000 Volt, und der Strahl weiterhin durch die zweite Spannungsquelle fokussiert wird, dann erhält man einen scharf gebündelten Ionenstrahl 34 mit sehr hochenergetischen Ionen.

Fig. 2 zeigt ein zweites Ausführungsbeispiel, das besonders für Anwendungen geeignet ist, wo ein scharf gebündelter Ionenstrahl 34 erwünscht ist und wo die Ionen ein relativ niedriges Energieniveau haben. Das zweite Beispiel besitzt ebenfalls einen hochohmigen Körper 12 mit einem ersten Ende 14 und einem zweiten Ende 16, an welchen eine erste Elektrode 18 und eine zweite Elektrode 20 angebracht sind. Eine erste Spannungsquelle 28 liefert wie im ersten Ausführungsbeispiel die Beschleunigungsspannung. Die Ionenquelle für das zweite Ausführungsbeispiel ist jetzt ionisierbares Festkörpermaterial 30' im Bereich der ersten Elektrode 18, das Ionen emittiert, wenn es mit Elektronen beschossen wird.

Weiterhin ist bei dem zweiten Ausführungsbeispiel eine Fokussiereinrichtung in dem Raum zwischen der zweiten Elektrode 20 und dem Target 32 vorgesehen. Eine solche Fokussiereinrichtung enthält eine oder mehrere Elektroden, die beispielsweise als Lochblenden oder Zylinder ausgebildet sind. Zur Erläuterung des Prinzips ist eine fokussierende Elektrode 44 in der Fig. 2 dargestellt. In diesem Beispiel unterhält die zweite Spannungsquelle 31 eine Potentialdifferenz zwischen der zweiten Elektrode 20 und dem Target 32. Eine dritte Spannungsquelle 46 ist zwischen der zweiten Elektrode 20 und der fokussierenden Elektrode 44 vorgesehen. Mit Hilfe der Fokussiereinrichtung kann der Ionenstrahl weiter im gewünschten Sinne beeinflusst werden.

Weitere nicht gesondert dargestellte Ausführungsbeispiele der Erfindung verwenden eine Mehrzahl von parallel angeordneten kapillaren Längskanälen. Mit solchen dichtgepackten Vielfachanordnungen von Ionengeneratoren können parallele Ionenstrahlen erzeugt werden, die auf das Target einfallen.

Der beschriebene Ionengenerator ist für eine ganze Reihe von industriellen Anwendungen geeignet. Dazu gehört die Halbleiterindustrie, die materialverarbeitende Industrie und der Bereich der Materialprüfung. Bei Anwendungen in der elektronischen Industrie, insbesondere bei der Halbleiterherstellung, werden Ionenquellen für Kathoden-Aufsprühverfahren und für durch Ionenstrahlung unterstützte abtragende Bearbeitungsverfahren, auch chemischer Art verwendet. Weiter werden in der Halbleitertechnik Ionenstrahlen für Ionenimplantation verwendet, für das Speichern und Wiedergewinnen von Information, für das Dotieren von Halbleitern und für das Anbringen von selektiven Oberflächenveränderungen, um beispielsweise elektronische Schaltungen zu verändern oder für bestimmte Zwecke anzupassen. Die materialverarbeitende Industrie benutzt Ionenstrahlen zum Behandeln von Oberflächen von Kunststoffen, um ihre Eigenschaften zu verbessern. Auch kann man die Oberflächen von Metallen durch Bombardierung mit Ionen behandeln, um an der Oberfläche eine amorphe Schicht herzustellen, wodurch beispielsweise die Korrosionsfestigkeit verbessert wird. Auch kann die Implantation von Ionen dazu verwendet werden, die chemische Zusammensetzung der Oberfläche zu verändern und so auch die physikalische Eigenschaften zu ändern.

Im Bereich der Materialprüfung verwendet man Ionenstrahlen, um selektiv Schichten an der Oberfläche abzutragen und das Material zu analysieren. Die Schichten können dann einzeln studiert werden.

P A T E N T A N S P R U E C H E

1.     Ionengenerator zum örtlichen Beaufschlagen eines Targets (32) in einer Vakuumkammer (36), mit einem Längskanal, an dessen Enden (14, 16) Elektroden (18, 20) zum Anlegen einer Beschleunigungsspannung vorgesehen sind, dadurch gekennzeichnet, dass ein hochohmiger Körper (12) mindestens einen kapillaren Längskanal (22) enthält, dass die Innenseite jeder Kapillare eine Oberfläche (24) aufweist, welche die Emission von Sekundärelektronen (42) begünstigt, und dass benachbart einer Elektrode (18) eine Quelle (30') von durch Elektronen ionisierbarem Material vorgesehen ist.

2.     Ionengenerator nach Anspruch 1, dadurch gekennzeichnet, dass der kapillare Längskanal (22) eine effektive Durchlassbreite (t) kleiner als 200 μm aufweist, und dass das Verhältnis seiner Längenausdehnung (1) zur genannten Durchlassbreite im Bereich zwischen 100:1 und 1000:1 liegt.

3.     Ionengenerator nach Anspruch 2, dadurch gekennzeichnet, dass der kapillare Längskanal zylindrisch ist, und dass die effektive Durchlassbreite sein Innendurchmesser ist.

4.     Ionengenerator nach Anspruch 2, dadurch gekennzeichnet, dass der kapillare Längskanal prismatisch ist, und dass die effektive Durchlassbreite der Durchmesser des in den prismatischen Querschnitt eingeschriebenen Kreises ist.

5.     Ionengenerator nach Anspruch 1, dadurch gekennzeichnet, dass die Innenseite (24) des kapillaren Längskanals (22) von einem Gebiet (26) einer Auskleidung aus

0020899

einem Material umgeben ist, das die Oberfläche der Innenseite teilweise leitend macht.

6.      Ionengenerator nach Anspruch 5, dadurch gekennzeichnet, dass der elektrische Widerstand des hochohmigen Körpers (12) mehr als $10^6$ Ohm beträgt, und dass der zwischen den Elektroden (18, 20) gemessene Gesamtwiderstand des Körpers einschliesslich der Auskleidung im Bereich zwischen $10^6$ und $10^{10}$ Ohm liegt.

7.      Ionengenerator nach Anspruch 1, dadurch gekennzeichnet, dass ausser der an die erste (18) und an die zweite (20) Elektrode angeschlossenen einstellbaren ersten Spannungsquelle (28) für die Beschleunigungsspannung (V1) im Bereich von 200 Volt bis 5000 Volt eine zweite Spannungsquelle (31) zum Vorspannen des Targets (32) bezüglich der zweiten Elektrode (20) vorgesehen ist.

8.      Ionengenerator nach Anspruch 7, dadurch gekennzeichnet, dass beide Spannungsquellen (28, 31) im Verhältnis bis 1:9 gegen einander verstellbar sind.

9.      Ionengenerator nach Anspruch 7, dadurch gekennzeichnet, dass zwischen der zweiten Elektrode (20) und dem Target (32) eine Fokussiereinrichtung für den Ionenstrahl (34) vorgesehen ist.

10.      Ionengenerator nach Anspruch 9, dadurch gekennzeichnet, dass mindestens eine fokussierende Elektrode (44) vorgesehen ist, die an eine dritte Spannungsquelle (46) angeschlossen ist.

11.      Ionengenerator nach Anspruch 1, dadurch gekennzeichnet, dass die Quelle von ionisierbarem Material ein Vorratsbehälter (30) ist, der ein entsprechendes Material in gasförmigem oder flüssigen Zustand enthält.

12.      Ionengenerator nach Anspruch 1, dadurch gekennzeichnet, dass die Quelle von ionisierbarem Material ein
Festkörper (30') im Bereich der ersten Elektrode (18) ist,
der bei Beschuss durch Elektronen Ionen emittiert.

0020899

1/1

# FIG. 1

# FIG. 2

IBM-YO 978068

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A - 2 237 252 (FREMIOT)<br>+ Fig. 2 +<br>-- | 1,6 |
| | DE - A - 2 214 842 (BENDIX)<br>+ Fig. 1-4; Ansprüche +<br>-- | 1,4 |
| | DE - A - 2 143 460 (KNOF)<br>+ Seite 5, Zeilen 26-39; Seite 6, Zeile 5; Fig. 1,2; Patentansprüche +<br>-- | 7,9,11 |
| | DE - B - 2 044 797 (FRAUNHOFER)<br>+ Fig. 3; Spalte 4, Zeilen 53-68; Spalte 5, Zeilen 1-5 +<br>-- | 2,3,4 |
| | DE - A - 1 539 678 (BATELLE)<br>+ Fig. 1; Seite 4, Zeilen 20-35 +<br>---- | 8,11 |

**KLASSIFIKATION DER ANMELDUNG (Int. Cl.³)**

H 01 J 33/00

**RECHERCHIERTE SACHGEBIETE (Int. Cl.³)**

H 01 J 33/00

H 01 J 3/00

H 01 J 39/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 02-10-1980 | KRAL |

EPA form 1503.1 06.78